Europäisches Patentamt

European Patent Office

Office européen des brevets

(19)

(11) Publication number: **0 103 032**
**B1**

(12) EUROPEAN PATENT SPECIFICATION

(45) Date of publication of patent specification: **02.03.88**

(51) Int. Cl.⁴: **H 01 L 31/16**

(21) Application number: **82108309.4**

(22) Date of filing: **09.09.82**

(54) Semiconductor optocoupler.

(43) Date of publication of application:
**21.03.84 Bulletin 84/12**

(45) Publication of the grant of the patent:
**02.03.88 Bulletin 88/09**

(84) Designated Contracting States:
**DE FR GB**

(56) References cited:
**DE-A-2 304 148**
**DE-A-2 606 524**
**DE-A-2 950 649**
**FR-A-2 176 103**
**FR-A-2 262 407**
**FR-A-2 272 377**
**FR-A-2 339 959**

(73) Proprietor: **GENERAL ELECTRIC COMPANY**
**1 River Road**
**Schenectady New York 12305 (US)**

(72) Inventor: **Cook, James Stone**
**Sky High Road, R.D. No. 2**
**Tully New York 12159 (US)**
Inventor: **Lennon, James Anthony**
**19 the Glen Dublin Road**
**Newry Down Northern Ireland (GB)**

(74) Representative: **Grupe, Peter, Dipl.-Ing. et al**
**Patentanwaltsbüro Tiedtke-Bühling-Kinne-**
**Grupe-Pellmann-Grams-Struif Bavariaring 4**
**D-8000 München 2 (DE)**

Courier Press, Leamington Spa, England.

## Description

The present invention relates to a semiconductor optocoupler according to the prior art portion of claim 1.

A semiconductor optocoupler of this type is described in DE—A—26 06 524. This known optocoupler comprises an emitter emitting light in response to an electrical signal and mounted on a first terminal, said light being received by a detector which is mounted on a second terminal. Said emitter and said detector are spaced apart confronting each other at a predetermined distance, the light of the emitter being optically coupled via an optically transmissive dielectric material to the detector. In order to improve the coupling efficiency (i.e. the current transfer ratio) there is furthermore provided an electrically non-conductive optically reflective material encapsulating said dielectric material. Finally the whole device is enclosed in a body of non-conductive opaque material such that only the terminals are led to the outside.

In FR—A—2 339 959 there is described an optocoupler which is characterized by an optically transmissive plate, wherein the transmission of light is primarily between faces of the plate through the short thickness dimension thereof. The emitter and the detector are coupled to that plate via layers of optical transmissive coupling material. This coupling material is inevitably needed because of the critical optical arrangement of the plate versus detector/emitter in order to avoid reflection. Because of the limited thickness of the glass plate the isolation voltage of this known optocoupler can not be made very high.

It is the object of the present invention to provide a semiconductor optocoupler which has both an excellent current transfer ratio and a very high isolation voltage.

According to the invention this object is achieved by the advantageous features as indicated in the characterizing portion of claims 1 and 11.

According to the present invention there is provided a semiconductor optocoupler having both an excellent current transfer ratio and a very high isolation voltage between the emitter and detector. Moreover, the terminals of the optocoupler of the present invention can be far apart, as far as 2 millimeters in actual practice, which provides an isolation voltage of several thousand volts, yet in a structure which is cheap, simple and sturdy, so that there is the additional advantage of low cost easy assembly.

Advantageous developments of the present invention are indicated in the subclaims.

In the following the invention will be described in more detail with reference to the accompanying drawings, in which:

Figure 1 is a cut-away view of an optocoupler in accordance to this invention.

Figure 2 is a section view of the coupler of Figure 1.

Figures 3 through 5 are detailed sectional views of alternative embodiments of the invention.

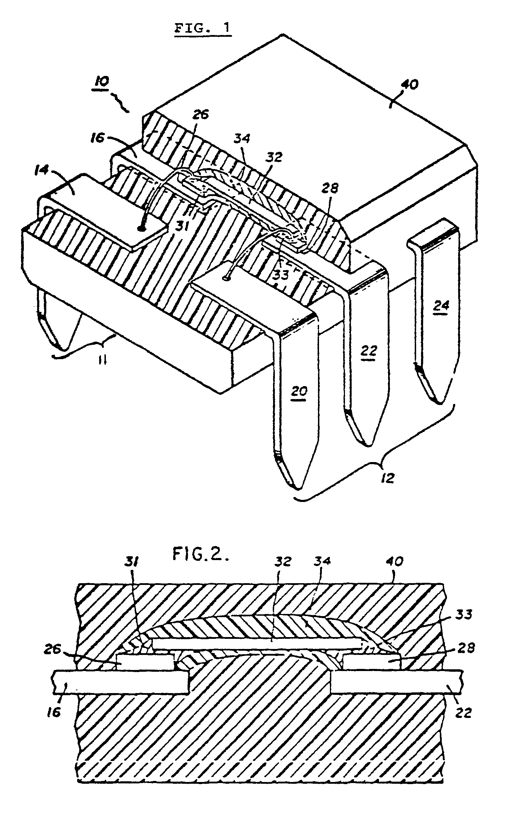

Referring now to Figures 1 and 2 an optocoupler 10 in accordance with this invention is illustrated which includes first and second sets of finger-like spaced apart terminals 11 and 12 each of which sets may include a number of individual terminals within that set such as terminals 14, 16 of set 11 and 20, 22 and 24 of set 12. The device of Figures 1 and 2 will be recognized as taking the form of the so-called dual-in-line package conventionally employed for a wide variety of semiconductor devices. Sets of terminals 11 and 12 are conveniently provided during manufacture of the device of Figure 1 in the form of a lead frame having the individual terminals supported therein by a detachable web of connecting material which is removed after certain fabrication steps employed in manufacturing the device are completed. Typically, the electrical terminals remain connected in the lead frame during the mounting of the semiconductor elements thereon and, where desired, through the encapsulation of the device in its outer protective housing afterwhich encapsulation the connecting material may be removed, the terminals being supported by the body of housing material.

The use of the dual-in-line package for housing optocouplers of the type to which this invention is addressed is per se known and it is only the combination thereof with the other features of this invention which provides the unique and heretofore unobtained advantages of this invention. An emitter 26 and a detector 28 are mounted on terminals 16 and 22, respectively. It is preferred in accordance with this invention that emitter 26 be a semiconductor light emitting diode which is responsive to an electrical input signal to generate a light output signal which light output signal may be a visible light output signal or an infrared light output signal or any other signal to which detector 28 is responsive. A variety of particular types of light emitting diodes are known such as semiconductor diodes fabricated of Group III—V semiconductor materials such as gallium arsenide or multi-component materials such as gallium aluminum arsenide, gallium aluminum arsenide phosphide and the like. Detector 28 mounted to an upper surface of terminal 22 is selected to be responsive to the light output signal generated by emitter 26 and to produce an electrical output signal. Typically, detector 28 takes the form of a light controlled semiconductor device to whose terminals an electrical output signal is applied which signal is controlled by the light output signal from emitter 26 as detected by detector 28. Thus in accordance with this invention the generation of an electrical output signal should be understood to mean not only the direct generation of an electrical signal but also the control of an externally applied electrical signal. In the past coupling between emitters and detectors has been accomplished through the use of a curable light transmissive dielectric medium disposed therebetween. This approach, often times referred to as the light cavity approach, has been effective in providing low cost optocouplers of reasonable performance but has not provided the maximum electrical isolation between the input and output terminals of the device that is sometimes required. Increased spacing has been effective to increase the isolation voltage of the device but at the expense of reduced efficiency of coupling between the emitter and detector elements.

This invention employs an optically transmissive dielectric rod-shaped member 32 disposed between emitter 26 and detector 28. Rod-shaped member (which in the following will be called "rod") 32 may conveniently be manufactured of glass, clear epoxy, plastic, fiber optic waveguide or any other light transmissive material. In form rod 32 may have a number of shapes as will be more fully described hereinbelow but is characterized by a generally elongate form to the ends of which the emitter and detector are coupled as distinguished from a plate of optically transmissive dielectric material as has been heretofore employed in certain coupler constructions wherein the transmission of light has been primarily between faces of the plate through the short thickness dimension thereof rather than along a rod of optically transmissive dielectric coupling material as is shown in Figures 1 and 2. In order to enhance coupling between emitter 26, detector 28 and the respective ends of rod 32, first and second layers of coupling material 31 and 33 are disposed between the emitter 26, the detector 28 and their respective ends of rod 32. It is preferred in accordance with this invention to employ a clear curable dielectric material such as clear silicone rubber, epoxy or the like for coupling layers 31 and 33.

The efficiency of coupling between the emitter and detector is greatly enhanced in accordance with this invention by providing on the surface of rod 32 a layer of electrically non-conductive optically reflective material 34 for enhancing the transmission of light from the emitter through rod 32 to the detector. Layer 34 may preferably take the form of a curable-resilient material such as silicone rubber, a reflective epoxy or the like any of which can conveniently be applied to the surface of rod 32 and which may if desired surround all or part of emitter 26, detector 28 and the optically transmissive coupling layers between the emitter and detector and the respective ends of rod 32. Reflective layer 34 is preferably chosen for its dielectric strength in addition to its reflective characteristics inasmuch as it bridges the gap between input electrical terminal 16 and output terminal 22 and could if of insufficient dielectric strength, provide a breakdown path therebetween. Still further, reflective layer 34 is chosen for its integrity of bonding both to dielectric rod 32 and coupling layers 31 and 33. It will be appreciated that the interfaces between the various elements which make up this invention especially those interfaces which intersect both the input and output terminals, provide a possible path for electrical breakdown therealong.

A body 40 of non-conductive opaque material surrounds the heretofore described elements of the invention. Body 40 may be formed of a material selected for its electrically insulative optically opaque characteristics such as epoxy, silicone molding compound and other similar materials. Typically housing 40 is formed by molding or the like. The particular materials and methods for forming housing 40 are well known and no particular deviations from prior art methods for forming such housings need be made except to insure that the interface between housing 40 and the outer surface of reflective material 34 is of sufficient dielectric strength to insure that breakdown does not occur therealong. The techniques described by US—A—4 271 365 are advantageously employed herein.

Referring specifically now to Figure 2 a cross-sectional view of a portion of the device illustrated at Figure 1 is shown for the purpose of more clearly illustrating the precise construction of rod 32 and the placement thereof with respect to emitter 26 and detector 28 as well as the application of reflective layer 34 thereto. Figure 2 includes the innermost portions of terminals 16 and 22, emitter pellet 26, detector pellet 28, rod 32a and reflective layer 34. Omitted from Figure 2 are the end portions of terminals 16 and 22 as well as the encapsulating body 40. Emitter 26 and detector 28 are attached to leads 16 and 22 respectively in a conventional manner such as by soldering, welding, attachment by an alloy layer, a conductive adhesive, or the like. It will be understood that electrical contact to emitter 26 and detector 28 may conveniently be made to one terminal thereof by a low resistance connection between an electrode on the lower surface of the emitter and detector pellets respectively and to further terminals of the emitter and detector by means of leads connected between electrodes on the upper surface of the devices and electrical terminals 14, 18, 20 and 24.

Optical coupling between emitter 26 and rod 34 is enhanced through the use of coupling layer 31 disposed between the emitter pellet and the end of rod 34. Layer 31 may conveniently be clear silicone such as Dow Corning 6101 or 3140. It is preferred that coupling layer 31 be applied and only partially cured prior to the application of reflective layer 34. Similarly, coupling layer 33 enhances the transfer of optical energy from bar 32a to detector 28. Layer 33 is conveniently formed of the same material as layer 31. In accordance with this invention it is preferable to apply coupling layers 31 and 33 to the emitter and detector pellets respectively in liquid or semiliquid flowable form and then to place rod 32 in contact therewith and held thereby afterwhich the assembly is heated to an elevated temperature to partially cure layers 31 and 33 and to anchor rod 32 in a position thereon. After such partial curing reflective layer 34 is applied over rod 32 as well as over coupling layers 31 and 33 and portions of emitter 36 and detector 28. After the application of reflective layer 34, preferably in liquid form, layer 34 is cured by heating to an elevated temperature which heating step simultaneously completes the curing of layers 31 and 33 and therefore insures a high breakdown voltage interface therebetween. Non-conductive reflective coating 34 is preferably a layer of silicone with a reflective material such as titanium dioxide mixed therewith. Layer 34 must be selected to adhere to bar 32 as well as to coupling layers 31 and 33. It has been found that a mixture of about 5 to 1 by weight silicone rubber with titanium dioxide provides a reflective coating which substantially increases the efficiency of coupling between emitter 26 and detector 28. In accordance with the embodiment of the invention illustrated at Figure 2, rod 32 may conveniently take a cylindrical or rectangular cross-sectional form, the ends of which are disposed on emitter 26 and detector 28 in proximity to light generating and light sensitive regions thereof respectively.

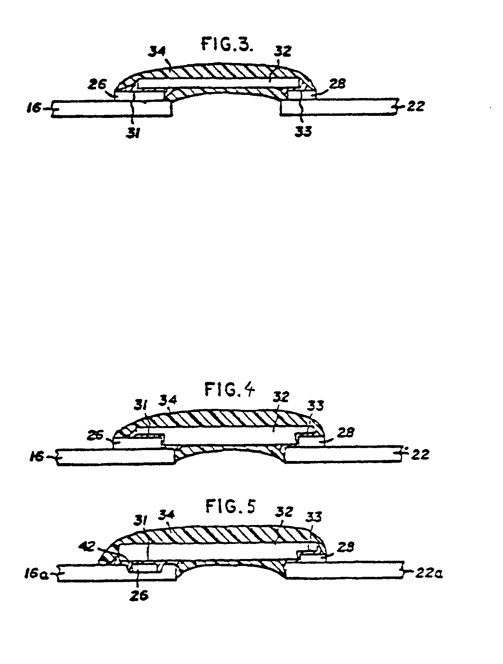

While the invention as thus far described provides a number of significant advantages over the prior art, particularly in the area of achieving higher isolation voltages between the input and the output terminals, further modifications and changes therein may be utilized to provide further advantages, particularly as to the efficiency of light coupling between the emitter and detector devices. A number of structures illustrative of such modifications and changes are illustrated in Figures 3 through 5 wherein detailed views of that portion of the structure of this invention hereinabove illustrated at Figure 2 are depicted. Where common elements are included in the several views, like reference numerals are utilized to indicate such elements. For example, terminals 16 and 22 of Figures 3 and 4 are substantially identical in form to terminals 16 and 22 of Figures 1 and 2. Terminals 16a, 16b and 16c, as well as terminals 22a, 22b and 22c of Figure 5 are slight variations of the terminals illustrated in Figures 1 through 4. For reference, Figure 3 shows essentially the same structure of device as illustrated in Figures 1 and 2.

In accordance with the embodiment of this invention illustrated at Figure 4, both ends of rod 32 may be appropriately notched or otherwise contoured in order to provide enhanced coupling to both the side and upper surfaces of emitter 28 and detector 31.

It is an additional advantage of the structure of Figure 4 that enhanced positional stability between rods 32 and the emitter and detector pellets during the assembly of the device is provided by the notches. Longitudinal stability is provided by the notches themselves which restrict displacement of the rod and additionally by the increased contact area between the rod, coupling layer 31 and 33 and their respective emitter and detector pellets due to the contoured rod ends. It will be understood that the particular embodiment of the invention illustrated for example at Figure 4 does not attempt to depict each and every possible configuration that the invention may take which includes one or more contoured end portions in a rod coupling an emitter and detector pellet. For example, it may be desirable to provide a notch at the detector end and not the emitter end which configuration is not illustrated. Further, the particular configuration of notch may well be matched to the shape of the pellet in order to further enhance the efficiency of light coupling between the pellet and the rod.

A further structural approach for increasing the efficiency of coupling between either the emitter or detector and the light transmissive rod is illustrated in an exemplary embodiment of this invention shown at Figure 5. A recess 42 is provided in terminal 16 for receiving pellet 26. Preferably recess 40 may be formed by coining lead 16 or by other methods for forming such a recess as may be well known to those skilled in the art. It is preferred that recess 42 be of a shape which maximizes the efficiency of light coupling between the pellet and the end of rod 32 and recess 42 may be coated with a reflection enhancing coating such as tin. While not illustrated, it will be appreciated that a recessed area may be provided in either or both of leads 16 and 22 depending on the particular configuration of pellets employed for the emitter and detector functions. It will be further appreciated that while a rectangular recess has been illustrated in each case, corresponding to rectangular shaped pellets as are illustrated herein, that where pellets having different shapes are employed the shape of the recess may be changed in order to match the shape of the pellet.

## Claims

1. A semiconductor optocoupler comprising an electrically insulative supporting substrate on which are situated first and second finger-like terminals (16, 22) having inner ends confronting each other in spaced relation along the width of said substrate, an emitter (26) responsive to an electrical input signal to generate a light output signal and mounted on one (16) of said terminals adjacent its inner end, a detector (28) responsive to said light output signal to generate an electrical output signal and mounted on the other (22) of said terminals adjacent to its inner end, an optically transmissive dielectric material (32) being encapsulated by an electrically non-conductive optically reflective material (34), and a body (40) of electrically non-conductive opaque material enclosing said optocoupler, the outer ends of respective terminals extending from said body and providing external electric connections for said emitter and detector, characterized in

(a) that said optically transmissive dielectric material is a rod-shaped member (32) having a flat bottom portion at one end mounted on and supported by said emitter and in light receiving relation with said emitter, said rod-shaped member having a flat bottom portion at its other end mounted on and supported by said detector and in light transmitting relation with said detector, said rod-shaped member spanning the gap across said substrate between the emitter and the detector and being operative to optically couple light from said emitter to said detector while maintaining electrical isolation therebetween, and in

(b) that a first layer (31) of optically transmissive material is disposed between said emitter and said one end of said rod-shaped member and is operative to enhance the coupling of said light output signal from said emitter to said one end, and a second layer (33) of optically transmissive material is disposed between said detector and said other end of said rod-shaped member and is operative to enhance the coupling of said light output signal from said other end to said detector.

2. Semiconductor optocoupler according to claim 1, characterized in that said emitter (26) comprises a semiconductor light emitting diode.

3. Semiconductor optocoupler according to claim 1 or 2, characterized in that said detector (28) comprises a semiconductor light responsive detector.

4. Semiconductor optocoupler according to one of the preceding claims, characterized in that the optically transmissive dielectric material of said rod-shaped member is selected from glass, plastic, clear epoxy or fiber optic waveguide.

5. Semiconductor optocoupler according to one of the preceding claims, characterized in that said first and second layers (31, 33) of optically transmissive material comprise clear, curable dielectric coupling material.

6. Semiconductor optocoupler according to claim 5, characterized in that said coupling material (31, 33) comprises clear silicon rubber.

7. Semiconductor optocoupler according to one of the preceding claims, characterized in that said rod-shaped member is a length of fiber optic waveguide (32) and said electrically non-conductive optically reflective material (34) is the cladding of said waveguide.

8. Semiconductor optocoupler according to one of claims 1 to 6, characterized in that said electrically non-conductive optically reflective material (34) is a layer of curable material.

9. Semiconductor optocoupler according to claim 8, characterized in that said electrically non-conductive optically reflective material (34) is a layer of silicone rubber including a small amount of reflectivity enhancing material therein.

10. Semiconductor optocoupler according to claim 9, characterized in that said reflectivity enhancing material (34) comprises titanium dioxide.

11. A method for making a semiconductor optocoupler comprising the steps of

A) providing first and second spaced apart sets of electric terminals (16, 22),

B) mounting an emitter (26) on said first set of terminals (16) and an detector (28) on said second set of terminals (22) and providing electrical connection between said emitter (26) and detector (28) and said first and second sets of terminals (16, 22) respectively while maintaining electrical isolation between said emitter and detector,

C) applying a first coupling layer (31) of optically transmissive material to said emitter (26) and a second coupling layer (33) of optically transmissive material to said detector (28),

D) disposing a rod-shaped member (32) of glass between said emitter and detector in contact with said first and second coupling layers,

E) coating said rod (32) with an electrically non-conductive optically reflective material (34) and

F) encapsulating said optocoupler in a rigid body (40) of electrically non-conductive opaque material.

12. Method according to claim 11, characterized in that for carrying out step A) a lead frame including said terminals and a detachable web of connecting material are provided, said web of connecting material being removed after at least said mounting step.

13. Method according to claim 12, characterized in that for carrying out step B) said emitter (26) is attached to a first terminal (16), said detector (28) is attached to a second terminal (22) and the remaining terminals (14, 20, 24) are connected to electrodes on said emitter and detector with suitable connecting means.

14. Method according to claim 11, characterized in that for carrying out steps C) and D) first and second layers of curable light transmissive material are applied to said emitter (26) and detector (28) respectively, said rod-shaped member (32) is attached to said first and second layers and said layers then are cured to mechanically hold said rod-shaped member and to form a light transmissive interface (31, 33) between the ends of said rod-shaped member and said emitter and detector respectively.

15. Method according to claim 14, characterized in that for carrying out step E) a layer of curable reflective material is applied to said rod-shaped member (32) and cured.

16. Method according to claim 15, characterized in that said light transmissive interfaces (31, 33) are coated with reflective material which then is cured.

**Patentansprüche**

1. Halbleiter-Optokoppler mit einem elektrisch isolierenden Stützsubstrat, auf dem erste und zweite fingerförmige Anschlüsse (16, 22) angeordnet sind, deren innere Enden einander, bezogen auf die Breite des Substrats, in Abstand gegenüber liegen, mit einem Sendeelement (26), das im Ansprechen auf ein elektrisches Eingangssignal ein Licht-Ausgangssignal erzeugt und auf einem (16) der Anschlüsse in der Nähe des inneren Endes desselben befestigt ist, mit einem Detektorelement (28), das im Ansprechen auf das Licht-Ausgangssignal ein elektrisches Ausgangssignal erzeugt und auf dem anderen (22) der beiden Anschlüsse in der Nähe des inneren Endes desselben befestigt ist, mit einem optisch durchlässigen, dielektrischen Material (32), das von einem elektrisch nichtleitenden, optisch reflektierenden Material (34) ummantelt ist, sowie mit einem den Optokoppler umgebenden Körper (40) aus elektrisch nichtleitendem, opakem Material, wobei die äußeren Enden der Anschlüsse aus dem Körper herausragen und externe elektrische Verbindungen für das Sende- und das Detektorelement bilden, dadurch gekennzeichnet, daß

(a) das optisch durchlässige, dielektrische Material ein stangenförmiges Teil (32) ist, das an seinem einen Ende einen flachen Basisbereich, der auf dem Sendeelement befestigt ist, von diesem getragen wird und in Lichtempfangsbeziehung zu diesem steht, sowie an seinem anderen Ende einen flachen Basisbereich aufweist, der auf dem Detektorelement befestigt ist, von diesem getragen wird und in Lichtempfangsbeziehung zu diesem steht, wobei das stangenförmige Teil den Spalt zwischen dem Sendeelement und dem Detektorelement überspannt und das Licht aus dem Sendeelement optisch mit dem Detektorelement bei gleichzeitiger Aufrechterhaltung der elektrischen Isolation zwischen denselben koppelt, und daß

(b) eine erste Schicht (31) aus optisch durchlässigem Material zwischen dem Sendeelement und dem einen Ende des stangenförmigen Teils zur Verbesserung des Kopplungsfaktors des Licht-Ausgangssignals aus dem Sendeelement zu dem einen Ende angeordnet und eine zweite Schicht (33) aus optisch durchlässigem Material zwischen dem Detektorelement und dem anderen Ende des stangenförmigen Teils zur Verbesserung des Kopplungsfaktors des Licht-Ausgangssignals aus dem anderen Ende zu dem Detektorelement angeordnet ist.

2. Halbleiter-Optokoppler nach Anspruch 1, dadurch gekennzeichnet, daß das Sendeelement (26) eine Halbleiter-Leuchtdiode aufweist.

3. Halbleiter-Optokoppler nach Anspruch 1 oder 2, dadurch gekennzeichnet, daß das Detektorelement (28) einen Halbleiter-Lichtsensor aufweist.

4. Halbleiter-Optokoppler nach einem der vorangehenden Ansprüche, dadurch gekennzeichnet, daß das optisch durchlässige, dielektrische Material des stangenförmigen Teils Glas, Plastik, klares Epoxidharz oder eine Lichtleiterfaser ist.

5. Halbleiter-Optokoppler nach einem der vorangehenden Ansprüche, dadurch gekennzeichnet, daß die erste und die zweite Schicht (31, 33) aus optisch durchlässigem Material klares, schmelzbares dielektrisches Kopplungsmaterial enthält.

6. Halbleiter-Optokoppler nach Anspruch 5, dadurch gekennzeichnet, daß das Kopplungsmaterial (31, 33) klaren Silikongummi enthält.

7. Halbleiter-Optokoppler nach einem der vorangehenden Ansprüche, dadurch gekennzeichnet, daß das stangenförmige Teil ein Stück einer Lichtleiterfaser (32) ist und daß das elektrisch nichtleitende, optisch reflektierende Material (34) die Umhüllung der Lichtleiterfaser ist.

8. Halbleiter-Optokoppler nach einem der Ansprüche 1 bis 6, dadurch gekennzeichnet, daß das elektrisch nichtleitende, optisch reflektierende Material (34) ein Schicht aus schmelzbarem Material ist.

9. Halbleiter-Optokoppler nach Anspruch 8, dadurch gekennzeichnet, daß das elektrisch nichtleitende, optisch reflektierende Material (34) eine Schicht aus Silikongummi ist, der eine geringe Menge an Reflexionsverstärkungsmaterial enthält.

10. Halbleiter-Optokoppler nach Anspruch 9, dadurch gekennzeichnet, daß das Reflexionsverstärkungsmaterial (34) Titandioxid enthält.

11. Verfahren zur Herstellung eines Halbleiter-Optokopplers, gekennzeichnet durch folgenden Schritte:

A) Vorsehen eines ersten und eines zweiten, voneinander beabstandeten Satzes von elektrischen Anschlüssen (16, 22),

B) Befestigen eines Sendeelements (26) auf dem ersten Satz von Anschlüssen (16) und eines Detektorelements (28) auf dem zweiten Satz von Anschlüssen (22) und Schaffen eines elektrischen Anschlusses zwischen dem Sendeelement (26) bzw. dem Detektorelement (28) und dem ersten bzw. dem zweiten Satz von Anschlüssen (16, 22) bei gleichzeitiger Aufrechterhaltung einer elektrischen Isolation zwischen dem Sende- und dem Detektorelement,

C) Aufbringen einer ersten Kopplungsschicht (31) aus optisch durchlässigem Material auf das Sendeelement (26) und einer zweiten Kopplungsschicht (33) aus optisch durchlässigem Material auf das Detektorelement (28),

D) Anordnen eines stangenförmigen Teils (32) aus Glas zwischen das Sende- und das Detektorelement in Kontakt mit der ersten und der zweiten Kopplungsschicht,

E) Beschichten der stangenförmigen Teils (32) mit einem elektrisch nichtleitenden, optisch reflektierenden Material (34), und

F) Einkapseln des Optokopplers in einen harten Körper (40) aus elektrisch nichtleitendem, opakem Material.

12. Verfahren nach Anspruch 11, dadurch gekennzeichnet, daß zur Durchführung des Schrittes A) ein Leiterrahmen mit den Anschlüssen und einem entfernbaren Arm eines Anschlußmaterials vorgesehen wird, wobei der Arm des Anschlußmaterials spätestens nach dem Befestigungsschritt entfernt wird.

13. Verfahren nach Anspruch 12, dadurch gekennzeichnet, daß zur Durchführung des Schrittes B) das Sendeelement (26) an einem ersten Anschluß (16), das Detektorelement (28) an einem zweiten Anschluß befestigt wird und die verbleibenden Anschlüsse (14, 20, 24) mittels geeigneter Befestigungseinrichtungen mit Elektroden an dem Sende- und dem Detektorelement verbunden werden.

14. Verfahren nach Anspruch 11, dadurch gekennzeichnet, daß zur Durchführung der Schritte C) und D) auf das Sendeelement (26) und das Detektorelement (28) eine erste bzw. eine zweite Schicht eines schmelzbaren, lichtdurchlässigen Materials aufgebracht wird, das stangenförmige Teil (32) auf die erste und zweite Schicht aufgebracht wird und die Schichten anschließend ausgehärtet werden, um das stangenförmige Teil mechanisch festzuhalten und um eine lichtdurchlässige Schnittstelle (31, 33) zwischen den Enden des stangenförmigen Teils und dem Sende- bzw. dem Detektorelement zu bilden.

15. Verfahren nach Anspruch 14, dadurch gekennzeichnet, daß zur Durchführung des Schrittes E) eine Schicht aus schmelzbarem, reflektierendem Material auf das stangenförmige Teil (32) aufgebracht und gehärtet wird.

16. Verfahren nach Anspruch 15, dadurch gekennzeichnet, daß die lichtdurchlässigen Schittstellen (31, 33) mit reflektierendem Material beschichtet werden, das anschließend gehärtet wird.

## Revendications

1. Photocoupleur à semi-conducteur comprenant un substrat de support isolant vis-à-vis de l'électricité sur lequel sont situées des première et seconde bornes en forme de doigt (16, 22) ayant des extrémités intérieures en regard l'une de l'autre, espécées l'une de l'autre, sur la largeur de substrat, un émetteur (26) répondant à un signal électrique d'entrée pour produire un signal de sortie de lumière et monté sur l'une (16) des bornes contiguë à son extrémité intérieure, un détecteur (28) répondant au signal de sortie de lumière pour produire un signal électrique de sortie et monté sur l'autre (22) des bornes contiguë à son extrémité intérieure, un matériau diélectrique transmettant la lumière (32) étant enrobé par un matériau réfléchissant la lumière non-conducteur de l'électricité (34), et un corps (40) en matériau opaque non-conducteur de l'électricité enfermant la photocoupleur, les extrémités extérieures des bornes respectives s'étendant à partir du corps et fournissant des connexions électriques extérieures pour l'émetteur et lw détecteur, caractérisé

(a) en ce que le matériau diélectrique transmettant la lumière est un élément en forme de tige (32) ayant une partie inférieure plate à l'une de ses extrémités montée sur l'émetteur et supportée par celui-ci et en relation de réception de la lumière avec l'émetteur, l'élément en forme de tige comportant une partie inférieure plate à son autre extrémité montée sur le détecteur et supportée par celui-ci et en relation de transmission de la lumière avec le détecteur, l'élément en forme de tige recouvrant l'interstice à travers le substrat entre l'émetteur et le détecteur et pouvant être mis en oeuvre pour coupler optiquement la lumière provenant de l'émetteur au détecteur tout en maintenant entre eux l'isolement electrique, et,

b) en ce qu'une première couche (31) de matériau transmettant la lumière est disposée entre l'émetteur et la première extrémité de l'élément en forme de tige et peut être mise en oeuvre pour améliorer le couplage du signal de sortie de lumière entre l'émetteur et cette première extrémité, et un seconde couche (33) de matériau transmettant la lumière est disposée entre le détecteur et l'autre extrémité de l'élément en forme de tige et peut être mise en oeuvre pour améliorer le couplage du signal de sortie de lumière entre cette autre extrémité et le détecteur.

2. Photocoupleur à semi-conducteur selon la revendication 1, caractérisé en ce que l'émetteur (26) comprend une diode électroluminescente à semi-conducteur.

3. Photocoupler à semi-conducteur selon la revendication 1 ou la revendication 2, caractérisé en ce que le détecteur (28) comprend un détecteur sensible à la lumière à semi-conducteur.

4. Photocoupleur à semi-conducteur selon l'une des revendications précédentes, caractérisé en ce que le matériau diélectrique transmettant la lumière de l'élément en forme de tige est choisi parmi le verre, un matériau plastique, une époxy claire ou un guide d'ondes à fibre optique.

5. Photocoupleur à semi-conducteur selon l'une des revendications précédentes, caractérisé en ce que les première et seconde couches (31, 33) de matériau transmettant la lumière comprennent un matériau de couplage en diélectrique clair, durcissable.

6. Photocoupleur à semi-conducteur selon la revendication 5, caractérisé en ce que le matériau de couplage (31, 33) comprend du caoutchouc de silicone clair.

7. Photocoupleur à semi-conducteur selon l'une des revendications précédentes, caractérisé en ce que l'élément en forme de tige est un tronçon de guide d'ondes à fibre optique (32) et le matériau réfléchissant la lumière, non-conducteur de l'électricité (34) est l'habillage du guide d'ondes.

8. Photocoupleur à semi-conducteur selon l'une des revendications 1 à 6, caractérisé en ce que le matériau réfléchissant la lumière, non-conducteur de l'électricité (34) est une couche de matériau durcissable.

9. Photocoupleur à semi-conducteur selon la revendication 8, caractérisé en ce que le matériau réfléchissant la lumière, non-conducteur de l'électricité (34) est une couche de caoutchouc de silicone renfermant une petite quantité de matériau renforçant la réflectivité.

10. Photocoupleur à semi-conducteur selon la revendication 9, caractérisé en ce que le matériau renforçant la réflectivité (34) comprent du bioxyde de titane.

11. Procédé de fabrication d'un photocoupleur à semi-conducteur comprenant les étapes consistant à:

A) Fournir des premier et second jeux espacés de bornes électriques (16, 22);

B) Monter un émetteur (26) sur le premier jeu de bornes (16) et un détecteur (28) sur le second jeu de borne (22) et fournir une connexion électrique entre l'émetteur (26) et le détecteur (28) et entre les premier et second jeux de bornes (16, 22), respectivement, tout en maintenant une isolation électrique entre l'émetteur et le détecteur,

C) Appliquer une première couche de couplage (31) de matériau transmettant le lumière à l'émetteur (26) et une seconde couche de couplage (33) de matériau transmettant la lumière au détecteur (28),

D) Disposer un élément en forme de tige (32) en verre entre l'émetteur et le détecteur en contact avec les première et seconde couches de couplage,

E) Revêtir la tige (32) avec un matériau réfléchissant la lumière, non-conducteur de l'électricité (34) et

F) Noyer le photocoupleur dans un corps rigide (40) de matériau opaque, non-conducteur de l'électricité.

12. Procédé selon la revendication 11, caractérisé en ce que pour l'exécution de l'étape A), on fournit un cadre en fil comportant les bornes et un voile détachable de matériau de connexion, le voile de matériau de connexion étant enlevé après au moins l'étape de montage.

13. Procédé selon la revendication 12, caractérisé en ce que pour l'exécution de l'étape B), on fixe l'émetteur (26) à une première borne (16), on assujettit le détecteur (28) à une seconde borne (22) et on connecte les autres bornes (14, 20, 24) aux électrodes de l'émetteur et du détecteur par un moyen de liaison approprié.

14. Procédé selon la revendication 11, caractérisé en ce que pour l'exécution des étapes C) et D), on applique des première et seconde couches de matériau durcissable transmettant la lumière à l'émetteur (26) et au détecteur (28) respectivement, on fixe l'élément en forme de tige (32) aux première et seconde couches et on durcit alors les couches de manière à supporter mécaniquement l'élément en forme de tige et à former une interface transmettant la lumière (31, 33) entre les extrémités de l'élément en forme de tige et l'émetteur et le détecteur, respectivement.

15. Procédé selon la revendication 14, caractérisé en ce que pour l'exécution de l'étape E, on applique une couche de matériau réfléchissant durcissable est appliquée à l'élément en forme de tige (32) et la durcit.

16. Procédé selon la revendication 15, caractérisé en ce que les interfaces de transmission de la lumière (31, 33) sont revêtues d'un matériau réfléchissant qui est alors durci.

0 103 032

FIG. 1

FIG.2.

1

FIG.3.

FIG.4

FIG.5